# EUROPÄISCHE PATENTSCHRIFT

(11) **EP 1 916 720 B1**
(45) Veröffentlichungstag und Bekanntmachung des Hinweises auf die Patenterteilung: **24.12.2008**
(21) Anmeldenummer: 06291689.5
(22) Anmeldetag: 27.10.2006
(51) Int. Cl.: H01L 39/24

(54) **Verfahren zur Herstellung eines supraleitfähigen elektrischen Leiters**
Method for the production of superconducting electrical conductor
Procédé de fabrication pour un conducteur électrique supraconducteur

(43) Veröffentlichungstag der Anmeldung: 30.04.2008
(73) Patentinhaber: Nexans, 75008 Paris (FR)
(72) Erfinder: Allais, Arnaud, Dr., 22940 Saint Julien (FR); Isfort, Dirk, Dr. rer. nat., 50321 Brühl (DE); Theune, Claus-Friedrich, 30982 Pattensen (DE); Porcher, Klaus, 31275 Lehrte (DE)
(74) Vertreter: Döring, Roger

(56) Entgegenhaltungen:
- EP-A1- 0 977 282
- WO-A-20/04059041
- US-A- 5 872 081
- US-A- 5 968 877

## Beschreibung

Die Erfindung bezieht sich auf ein Verfahren zur Herstellung eines supraleitfähigen elektrischen Leiters, bei welchem eine Schicht aus einem Yttrium-Barium-Kupfer-Oxid (YBCO) als supraleitfähigem Material auf ein texturiertes metallisches Substrat aufgebracht wird (US-A-5 739 086).

Ein supraleitfähiger elektrischer Leiter besteht aus einem speziellen Material, das bei ausreichend tiefen Temperaturen in den supraleitfähigen Zustand übergeht. Der elektrische Widerstand eines entsprechend aufgebauten Leiters geht dadurch gegen Null. Geeignete supraleitfähige Materialien sind beispielsweise YBCO (Yttrium-Barium-Kupfer-Oxid) oder BSCCO (Wismut-Strontium-Kalzium-Kupfer-Oxid). Ausreichend niedrige Temperaturen für derartige keramische Materialen liegen beispielsweise zwischen 67 K und 110 K, um den supraleitfähigen Zustand zu erreichen. Entsprechende supraleitfähige Leiter werden als Hochtemperatur-Supraleiter bezeichnet. Geeignete Kühlmittel sind beispielsweise Stickstoff, Helium, Neon und Wasserstoff oder Gemische dieser Stoffe, jeweils in flüssigem Zustand.

Die eingangs erwähnte US-A-5 739 086 beschreibt unterschiedliche Verfahren zur Herstellung von Hochtemperatur-Supraleitern. Bei einem BSCCO-Supraleiter wird das BSCCO-Material beispielsweise in Pulverform in ein Rohr aus Silber eingefüllt und verdichtet. Durch mechanische Verformung des Rohres und anschließende Wärmebehandlung (Glühen) wird der supraleitfähige Zustand erreicht. Beim YBCO-Supraleiter, der wegen seiner hervorragenden elektrischen Eigenschaften besonders für elektrische Kabel und Wicklungen geeignet ist, wird auf ein beispielsweise biaxial texturiertes Band aus Metall als Substrat zunächst eine ebenfalls aus Metall bestehende Pufferschicht aufgebracht, auf welche anschließend das YBCO-Material aufgetragen wird. Das Subtrat besteht beispielsweise aus Nickel, Kupfer oder Eisen oder einer Legierung. Für die Pufferschicht werden beispielsweise Kupfer oder Silber eingesetzt. Das YBCO-Material wird abschließend ebenfalls durch Wärmebehandlung in den supraleitfähigen Zustand gebracht. Der so hergestellte supraleitfähige Leiter kann - wie schon erwähnt - mit Vorteil in elektrischen Kabeln sowie Wicklungen für elektrische Motoren und Magnete eingesetzt werden. Er kann dabei aber wegen der Bandform nur in einer Richtung gebogen werden.

Der Erfindung liegt die Aufgabe zugrunde, das eingangs geschilderte Verfahren so zu gestalten, daß sich ein leichter zu verarbeitender supraleitfähiger Leiter auf YBCO-Basis ergibt.

Diese Aufgabe wird gemäß der Erfindung dadurch gelöst,
- daß ein als Band vorliegendes, texturiertes metallisches Substrat zunächst in seiner Längsrichtung um einen langgestreckten, metallischen Träger mit kreisförmigem Querschnitt herum zu einem Schlitzrohr mit sich in Längsrichtung erstreckenden, an einem Schlitz aneinander liegenden Kanten geformt wird,
- daß das Schlitzrohr anschließend durch Verschweißen des Schlitzes geschlossen wird,
- daß das geschlossene Rohr danach bis zur Anlage am Träger heruntergezogen wird,
- daß darauf die Schicht aus supraleitfähigem YBCO-Material rundum auf das Rohr aufgebracht wird und
- daß abschließend die Wärmebehandlung durchgeführt wird.

Mit diesem Verfahren ist ein in den supraleitfähigen Zustand überführbarer elektrischer Leiter geschaffen, der in gleicher Weise wie herkömmliche drahtförmige Leiter verarbeitet werden kann. Eine besondere Richtung beim Biegen des Leiters ist nicht mehr erforderlich. Er eignet sich daher besonders zur Herstellung von Wicklungen für elektrische Motoren und Magneten, aber auch für den Aufbau elektrischer Kabel unter Einsatz herkömmlicher Vorrichtungen.

Das Verfahren nach der Erfindung wird anhand der Zeichnungen als Ausführungsbeispiel erläutert.

Es zeigen:
Fig. 1 schematisch eine Anordnung zur Durchführung des Verfahrens nach der Erfindung.
Fig. 2 bis 5 Schnittbilder aus Fig. 1 längs der Linien II - II bis V - V in vergrößerten Darstellungen.
Fig. 6 einen Querschnitt durch einen mit dem Verfahren herstellbaren supraleitfähigen Leiter.

Mit 1 ist ein metallischer Träger bezeichnet, der als Strang, Seil oder Rohr ausgeführt sein kann. Er besteht vorzugsweise aus Stahl und kann auch die Funktion als zugfestes zentrales Element für einen herzustellenden supraleitfähigen Leiter dienen. Der Träger 1 hat vorzugsweise einen zwischen 0,5 mm und 3,0 mm liegenden Außendurchmesser.

Um den Träger 1 herum wird aus einem als Band 2 vorliegenden, durch Vorbehandlung bereits texturierten metallischen Substrat ein Schlitzrohr 3 geformt, das mit Vorteil möglichst nahe am Träger 1 liegt. Seine sich in Längsrichtung erstreckende Kanten liegen an einem zunächst noch offenen Schlitz 4 aneinander. Das Band 2 wird dabei von einer Spule 5 abgezogen und in einer durch Rollen 6 angedeuteten Verformungseinrichtung zum Schlitzrohr 3 geformt. Es besteht beispielsweise aus Nickel, Kupfer oder Eisen oder einer Legierung. Das Band 2 hat in einer Vorbehandlungsstufe beispielsweise eine biaxiale Textur eingeprägt bekommen. Es hat vorzugsweise eine zwischen 50 µm und 150 µm liegende Dicke.

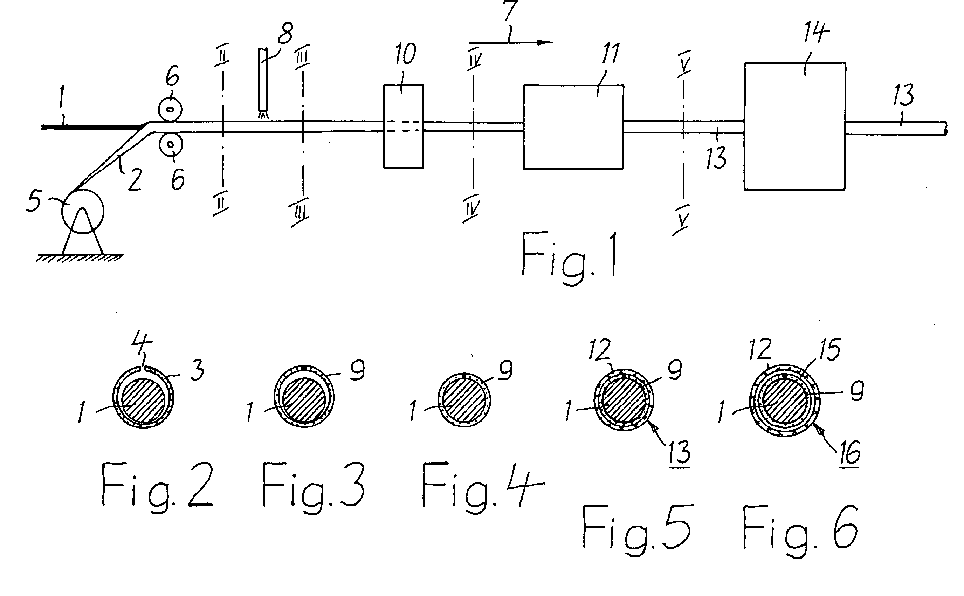

Träger 1 und Schlitzrohr 3 werden vorzugsweise kontinuierlich in Richtung des Pfeiles 7 bewegt. Dabei wird der Schlitz 4 des Schlitzrohres 3 im nächsten Arbeitsgang in einer Schweißeinrichtung 8 verschweißt, so daß sich ein durch eine Schweißnaht geschlossenes Rohr 9 ergibt. Die Schweißeinrichtung 8 kann beliebig ausgeführt sein. Es wird mit Vorteil eine Verschweißung unter Schutzgas nach dem Wolframinertgas (WIG)- oder dem Metallinertgas (MIG)-Verfahren oder eine Verschweißung mit einem Laserstrahl durchgeführt. Auch ein Schweißverfahren mit abbrennender Elektrode kann eingesetzt werden. Das geschlossene Rohr 9 wird danach in einer Zieheinrichtung 10 soweit in seinem Durchmesser reduziert, bis es am Träger 1 anliegt. Das entsprechende Element geht aus Fig. 4 hervor.

Das so erzeugte, kreisrunde Element wird anschließend in einer Anlage 11 rundum mit Schicht 12 aus YBCO-Material versehen. deren Dicke mit Vorteil zwischen 1 µm und 5 µm liegen kann. Das kann mit an sich bekannten Verfahren geschehen, wie beispielsweise dem PVD-Verfahren (Physical Vapor Deposition) oder dem CVD-Verfahren (Chemical Vapor Deposition) oder dem CSD-Verfahren (Chemical Solution Deposition). Hinter der Anlage 11 liegt dann ein fertiger, mit supraleitfähigem YBCO-Material beschichteter Leiter 13 (Fig. 5) vor, der abschließend in einer Einrichtung 14 zum Erreichen der Supraleitfähigkeit einer Wärmebehandlung unterzogen wird, vorzugsweise geglüht wird. Das kann mit Vorteil bei Temperaturen von 700 °C bis 850 °C durchgeführt werden.

Zum zusätzlichen Schutz des durch das Band 2 bzw. das Rohr 9 realisierten Substrats kann auf dasselbe vor der YBCO-Beschichtung noch eine rundum geschlossene Pufferschicht 15 mit einer Dicke von beispielsweise 100 nm bis 200 nm aufgebracht werden, die beispielsweise aus Keramik besteht. Geeignete Materialien sind beispielsweise Cerium-Oxid oder Lanthan-Zirkonium-Oxid. Die Pufferschicht 15 kann mit den gleichen Beschichtungsverfahren aufgebracht werden, wie sie für die YBCO-Schicht 12 angegeben sind. Auf die Pufferschicht 15 wird dann die YBCO-Schicht 12 wie beschrieben aufgebracht und es folgt die Wärmebehandlung in der Einrichtung 14. Ein Querschnitt durch einen entsprechend ergänzten supraleitfähigen Leiter 16 ist in Fig. 6 dargestellt.

## Patentansprüche

1. Verfahren zur Herstellung eines supraleitfähigen elektrischen Leiters, bei welchem eine Schicht aus einem Yttrium-Barium-Kupfer-Oxid (YBCO) als supraleitfähigem Material auf ein texturiertes metallisches Substrat aufgebracht und einer Wärmebehandlung unterzogen wird, **dadurch gekennzeichnet,**
- **daß** ein als Band (2) vorliegendes, texturiertes metallisches Substrat zunächst in seiner Längsrichtung um einen langgestreckten, metallischen Träger (1) mit kreisförmigem Querschnitt herum zu einem Schlitzrohr (3) mit sich in Längsrichtung erstreckenden, an einem Schlitz (4) aneinander liegenden Kanten geformt wird,
- **daß** das Schlitzrohr (3) anschließend durch Verschweißen des Schlitzes (4) geschlossen wird,
- **daß** das geschlossene Rohr (9) danach bis zur Anlage am Träger (1) heruntergezogen wird,
- **daß** darauf die Schicht (12) aus supraleitfähigem YBCO-Material rundum auf das Rohr (9) aufgebracht wird und
- **daß** abschließend die Wärmebehandlung durchgeführt wird.

2. Verfahren nach Anspruch 1, **dadurch gekennzeichnet, daß** vor dem Aufbringen der Schicht (12) aus YBCO-Material eine rundum geschlossene Pufferschicht (15) aus einem metallischen Material auf das Rohr (9) aufgetragen wird.

3. Mit dem Verfahren nach Anspruch 1 hergestellter supraleitfähiger elektrischer Leiter mit YBCO-Material als supraleitfähigem Material, **dadurch gekennzeichnet, daß** um einen metallischen Träger (1) mit kreisförmigem Querschnitt herum ein geschlossenes Rohr (9) aus einem texturierten metallischen Material angebracht ist, das rundum von einer Schicht (12) aus YBCO-Material umgeben ist.

4. Leiter nach Anspruch 3, **dadurch gekennzeichnet, daß** zwischen Rohr (9) und YBCO-Schicht (12) eine metallische Pufferschicht (15) angebracht ist.

## Claims

1. Method for producing a superconductive electrical conductor, in which a layer of an yttrium-barium-copper-oxide (YBCO) is applied as a superconductive material onto a textured metal substrate, and is subjected to a heat treatment, **characterized in**
- **that** a textured metal substrate, provided as a ribbon (2), is initially shaped in its longitudinal direction around an elongate metal support (1) with a circular cross section to form a slotted tube (3) having edges extending in the longitudinal direction and abutting at a slot (4),
- **that** the slotted tube (3) is next closed by welding the slot (4),
- **that** the closed tube (9) is then reduced in its diameter until it lies on the support (1),
- **that** the layer (12) of superconductive YBCO material is thereupon applied all around onto the tube (3), and
- **that** the heat treatment is finally carried out.

2. Method according to Claim 1, **characterized in that** a buffer layer (15) made of a metallic material, is applied around the tube (9) before applying the layer (12) of YBCO material.

3. Superconductive electrical conductor having YBCO material as a superconductive material, produced by the method according to Claim 1, **characterized in that** a closed tube (9) made of a textured metallic material, which is enclosed all around by a layer (12) of YBCO material, is applied around a metal support (1) with a circular cross section.

4. Conductor according to Claim 3, **characterized in that** a metal buffer layer (15) is supplied between the tube (9) and the YBCO layer (12).

## Revendications

1. Procédé de fabrication d'un conducteur électrique supraconducteur, dans lequel une couche d'oxyde d'yttrium, de baryum et de cuivre (YBCO) constituant le matériau supraconducteur est appliquée sur un substrat métallique texturé et subit un traitement thermique,
**caractérisé en ce que**
un substrat métallique texturé qui présente la forme d'une bande (2) est d'abord placé dans le sens de sa longueur autour d'un support métallique allongé (1) de section transversale circulaire pour former un tube fendu (3) dont les bords qui s'étendent dans le sens de la longueur sont adjacents l'un à l'autre le long d'une fente (4),
**en ce que** le tube fendu (3) est ensuite fermé par soudage de la fente (4),
**en ce que** le tube (9) fermé est ensuite rabattu jusqu'à venir se placer sur le support (1),
**en ce qu'**ensuite, la couche (12) de matériau d'YBCO supraconducteur est appliquée autour du tube (9) et
**en ce que** l'on réalise ensuite le traitement thermique.

2. Procédé selon la revendication 1, **caractérisé en ce qu'**avant l'application de la couche (12) en matériau d'YBCO, on applique autour du tube (9) une couche tampon fermée (15) en matériau métallique.

3. Conducteur électrique supraconducteur fabriqué à l'aide du procédé selon la revendication 1 et présentant un matériau d'YBCO comme matériau supraconducteur,
**caractérisé en ce que**
on applique autour d'un support métallique (1) de section transversale circulaire un tube (9) fermé en matériau métallique texturé qui est entouré par une couche (12) en matériau d'YBCO.

4. Conducteur selon la revendication 3, **caractérisé en ce qu'**une couche tampon métallique (15) est appliquée entre le tube (9) et la couche d'YBCO (12).
